(19) **Europäisches Patentamt**

**European Patent Office**

**Office européen des brevets**

(11) Publication number: **0 078 679**
**B1**

(12) **EUROPEAN PATENT SPECIFICATION**

(45) Date of publication of patent specification: **23.12.87**

(51) Int. Cl.⁴: **H 01 L 29/40, H 01 L 23/48**

(21) Application number: **82305765.8**

(22) Date of filing: **29.10.82**

(54) **An electrode connection structure in a semiconductor device.**

(30) Priority: **29.10.81 JP 174038/81**

(43) Date of publication of application:
**11.05.83 Bulletin 83/19**

(45) Publication of the grant of the patent:
**23.12.87 Bulletin 87/52**

(84) Designated Contracting States:
**DE FR GB**

(56) References cited:
**GB-A-2 024 506**

**IBM-TDB, vol. 21, no. 6, November 1978,
ARMONK (US), pages 2403-2405, G.E. ALCORN
et al.: "Silicon barrier layer metallurgy system
for ohmic or SBD contacts".**

**IBM-TDB, Vol. 22, No. 10, March 1980,
ARMONK (US), pages 4521, 4522, L.
BERENBAUM et al.: "Metal silicides for
schottky barrier diode applications".**

(73) Proprietor: **FUJITSU LIMITED
1015, Kamikodanaka Nakahara-ku
Kawasaki-shi Kanagawa 211 (JP)**

(72) Inventor: **Nakayama, Yoshiro
59-2, Shiratoridai Midori-ku
Yokohama-shi Kanagawa 227 (JP)**
Inventor: **Suzuki, Hidetake
14-33, Noge 1-chome Setagaya-ku
Tokyo (JP)**

(74) Representative: **Abbott, Leonard Charles et al
GILL JENNINGS & EVERY 53-64 Chancery Lane
London WC2A 1HN (GB)**

Courier Press, Leamington Spa, England.

## Description

The present invention relates to a semiconductor device, more particularly, an electrode connection structure in a semiconductor integrated circuit device.

A semiconductor integrated circuit device, in particular, one comprising a compound semiconductor such as gallium arsenide (GaAS), gallium arsenide/gallium aluminum arsenide (GaAs/GaAlAs), or indium phosphide (InP), often includes two or more types of electrodes of different materials interconnected with each other. For example, a metal semiconductor field effect transistor (MES FET) using GaAs has gate electrodes of, e.g., aluminum (Al), which makes Schottky contact with GaAs of an active region, and source and drain electrodes of, e.g., gold-germanium (AuGe), which makes ohmic contact with GaAs of the active region. A GaAs integrated circuit (IC) which is integrated with such MES FET's requires electrical connections between the above two types of electrodes.

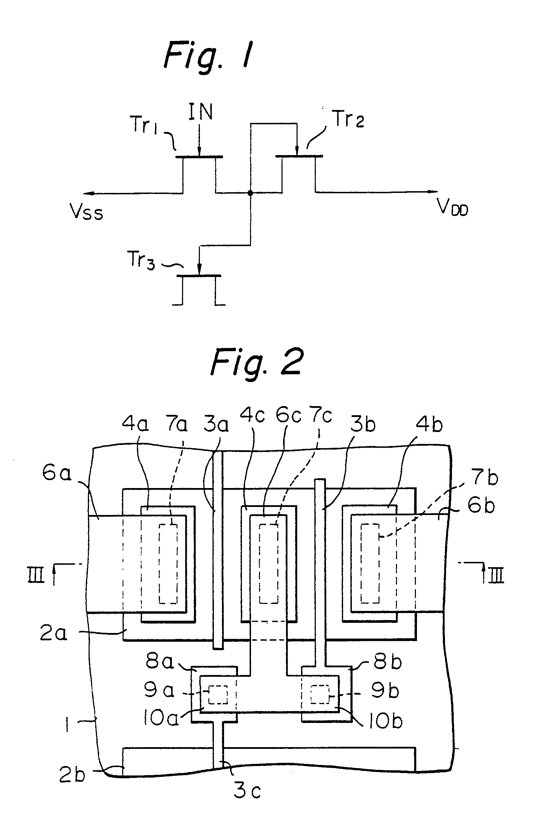

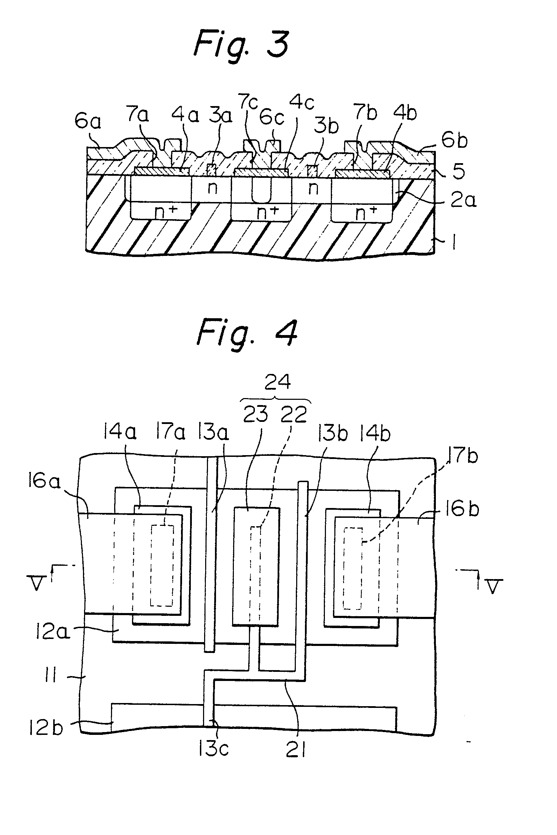

Figures 1 to 3 show an inverter circuit as an example of such connections. Figure 1 is a circuit diagram of an inverter circuit, Fig. 2 a plan view of the prior art patterns for elements of the inverter circuit of Fig. 1, and Fig. 3 a sectional view taken on the line III—III in Fig. 2. In this inverter circuit, a driver transistor $Tr_1$, a load transistor $Tr_2$, and a next stage driver transistor $Tr_3$ are MES FET's. The gate of the load transistor $Tr_2$ is connected to the source of the load transistor $Tr_2$ as well as the drain of the driver transistor $Tr_1$ and the gate of the next stage driver transistor $Tr_3$. In this inverter circuit, the gate of the driver transistor $Tr_1$ is an inlet terminal (IN). The drain of the load transistor $Tr_2$ is connected to one side of a power source ($V_{DD}$). The source of the driver transistor $Tr_1$ is connected to the other side of the power source or the ground ($V_{SS}$).

Referring to Figs. 2 and 3, in an insulating or semi-insulating GaAs substrate 1, active regions 2a and 2b exist as an N-type or $N^+$-type region on which gate electrodes 3a, 3b, and 3c and drain or source electrodes 4a, 4b, and 4c are formed, the metal of the gate electrodes 3a, 3b, and 3c and the metal of the drain or source electrodes 4a, 4b, and 4c being different and making Schottky contact and ohmic contact, respectively with GaAs. All the electrodes 3a, 3b, 3c, 4a, 4b, and 4c are covered with a silicon dioxide ($SiO_2$) layer 5 (not shown in Fig. 2). On the $SiO_2$ layer 5, interconnecting lines 6a and 6b made of, e.g., titanium-platinum-gold (TiPtAu) are formed, extending from the electrodes 4a and 4b through contact windows 7a and 7b, respectively. The $Tr_2$ gate electrode 3b, $Tr_2$ source and $Tr_1$ drain electrode 4c, and $Tr_3$ gate electrode 3c are connected by means of connecting portions 8a and 8b. Three through holes 7c, 9a, and 9b are opened in the $SiO_2$ layer 5 above the connecting portions 8a and 8b and the electrode 4c. These connecting portions 8a and 8b and the electrode 4c are connected by interconnecting lines 6c, 10a, and 10b made of TiPtAu.

The reason for connecting the gate electrode 3b and the drain or source electrode 4c by means of the interconnecting lines 6c, 10a, and 10b is that if the aluminum (Al) of the gate electrode and the gold-germanium (AuGe) of the drain or source electrode are directly connected with each other, the aluminum and the gold would react with each other to form purple plaque, an intermetallic compound, lowering the yield and reliability of the semiconductor device. Thus, the gate electrodes 3b, 3c and the drain or source electrodes 4c are connected by means of the interconnecting lines 6c, 10a, and 10b, by way respective through holes 7c, 9a, and 9b. Such connections may easily result in insufficient electrical contact between the interconnecting lines and the electrodes due to presence of $SiO_2$ residue in the through holes.

Further, connections made by means of through holes 9a and 9b require increased area for formation, since consideration must be given to tolerances in aligning the through holes 9a, 9b with the connecting portions 8a and 8b of the gate electrodes 3b and 3c respectively and in aligning the interconnecting lines 10a and 10b with the through holes 9a and 9b respectively. This increased area for through hole connections lowers the degree of integration of a semiconductor integrated circuit device having the above described inverter circuit.

Referring to Figs. 2 and 3, due to considerations of tolerances in alignment, the through holes 9a and 9b are formed in a square of 2 μm (microns) × 2 μm and the connecting portions 8a and 8b of the gate electrodes 3b and 3c are formed in a square of 6 μm × 6 μm. The interconnecting lines 10a and 10b are formed so as to include a square of 4 μm × 4 μm near the position of the through holes 9a, 9b. Further, there is a distance of about 2 μm between the connecting portions 8a and 8b of the gate electrodes 3b and 3c and the active region 2a and between the connecting portions 8a and 8b and the active region 2b. Therefore, 10 μm distance is needed between the active regions 2a and 2b.

The use of, for example, titanium-platinum-gold (TiPtAu) can be considered in place of aluminum as the gate-electrode metal so as to avoid the formation of the above-mentioned purple plaque and to avoid the increased area of connection portions by means of interconnecting lines and through holes. The titanium-platinum-gold line as an extending portion of gate electrodes can directly ride on the source or drain electrode and make contact between them without the formation of purple plaque, an intermetallic compound between aluminum and gold. The direct connection between the two types of electrodes of different metals enables elimination of the use of the interconnecting lines as well as the connection by means of through holes between the interconnecting lines and the electrodes, and, therefore, the decrease of the size necessary for making the connections between the two types of electrodes, that is, the elimination of the tolerances in alignment of layers at the through holes.

However, a titanium-platinum-gold electrode which makes Schottky contact with gallium arsenide cannot be formed before ohmic contact is formed since the heat treatment necessary for making the ohmic contact has an adverse effect on the Schottky contact. Therefore, the titanium-platinum-gold line as mentioned above can ride on the source or drain electrode only within the boundaries of the source or drain electrode, an ohmic contact-making electrode. This reduces the reliability of the contact between them and lowers the yield of the semiconductor device due to possible disconnection at the step appearing at the edge of the source or drain electrode. Further, the titanium-platinum-gold (TiPtAu) gate electrode does not allow source and drain regions to be made using the gate electrode as a mask for ion implantation or diffusion since the gate electrode cannot be made before the ohmic contact-making source and drain electrodes. This requires tolerances in alignment of the gate electrode with the source and drain regions, increasing the distance between the source and drain regions. This requirement also appears in the case of, e.g., aluminum gate electrode (see EP—A—0055932).

It is, therefore, an object of the present invention to eliminate the above-described problems.

A semiconductor device according to the present invention comprises a semiconductor layer defining at least one n-type active region and an ohmic electrode for the n-type active region consisting of different contact parts and is characterized in that the electrode includes: a first part formed on and in contact with the semiconductor layer and extending to the n-type active region, the first part comprising a material selected from the group consisting of high melting-point metals and a silicide of the group of high melting-point metals, and appropriate for making Schottky contact with the n-type active region; and a second part formed on and in contact with both the n-type active region and at least a portion of said first part of the electrode, the second part comprising a material different from the material of the first part of the electrode, and appropriate for making ohmic contact with the n-type active region, and the entire electrode, comprising the first and second parts, acting as an ohmic electrode for the n-tyoe active region.

In the preferred embodiment of the invention, the semiconductor layer defines a further n-type active region and a further electrode for this active region; the further electrode being formed on and in contact with the further n-type active region and comprising a material selected from the group of high melting-point metals and a silicide of the group of high melting-point metals, for making Schottky contact with the further active region; and the first part of the ohmic electrode comprising the same material as that of the further electrode, and extending from the further electrode.

High melting point metals which make Schottky contact with a semiconductor active region or layer include titanium tungsten (TiW); and silicides of high melting point metals which make Schottky contact with a semiconductor active region or layer include titanium tungsten silicide (TiWSi) and tungsten silicide (WSi). The Schottky contact made between one of these metals and a semiconductor is not adversely affected by the heat treatment for making ohmic contact, e.g. a temperature of 400°C to 450°C. This feature makes it possible to use more types of electrode structures than in the prior art.

GB—A—2 024 506 discloses the fabrication of a Ga-As field-effect transistor in which a non-alloyed ohmic contact to the semiconductor body is formed; it discloses a device defining at least one n type active region and an ohmic electrode for the n type active region consisting of different contact parts. Also, in IBM Technical Disclosure Bulletin, Vol. 21, No. 6 November 1978, pages 2403 to 2405, there is disclosed a silicon barrier layer metallurgy system for ohmic or Schottky contacts, in which electrodes contacting a silicon substrate comprise a barrier layer of a transition metal and an additional metal layer on top of the barrier layer.

In order that the invention may be better understood an embodiment thereof will now be described with reference to Figures 4 to 11 of the accompanying drawings. In the drawings Figures 1, 2 and 3, which have already been described, are respectively a circuit diagram of an inverter circuit; a partial plan view of a semi-conductor device in the prior art; and a sectional view taken along the line III—III in Figure 2;

Figure 4 is a partial plan view of a semiconductor device according to the present invention;

Figure 5 is a sectional view taken along the line V—V in Figure 4; and,

Figures 6 to 11 illustrate a process for fabricating the semiconductor device shown in Figure 4.

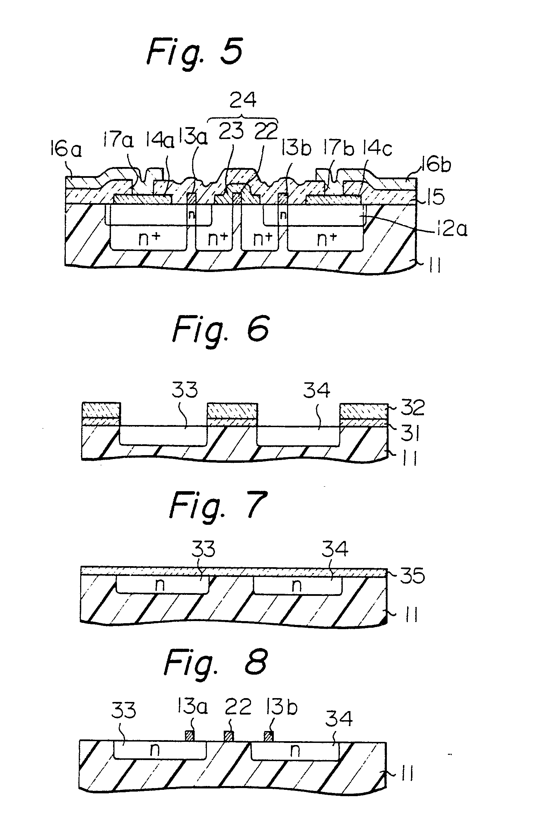

Figures 4 and 5 show an example of an inverter circuit embodying the present invention and similar in basic configuration to the inverter circuit of Figs. 1 to 3. In this example, gate electrodes 13a, 13b, and 13c are made of titanium tungstenide silicide (TiWSi) which makes Schottky contact with GaAs of a substrate 11. The gate electrodes 13b and 13c are formed without disconnection between them by extending the gate electrodes 13b and 13c on the surfaces of active regions 12b and 12a, respectively, to the surface of the semi-insulating substrate. The extending and connecting portion 21 of the gate electrodes 13b and 13c has a branch line 22 extending to a $Tr_1$-drain-electrode- and $Tr_2$-source-electrode-forming portion on the surface of the active region 12a. The gate electrodes 13a, 13b, and 13c and their extending portions 21 and 22 can be formed in one step by a lithographic technique. Further, the extending portion 22 of the gate electrode 13b and 13c on the active region 12a is covered with a gold-germanium (AuGe) alloy layer 23, the alloy of which makes ohmic contact with GaAs of the active region 12a. The AuGe layer 23 on the surface of the active region 12a surrounds the extending portion 22 and makes ohmic contact with the active region 12a at three sides of the extending portion 22 of the gate electrode 13b and 13c. Thus, the action of the Schottky contact of the extending portion 22, similar to the action of the gates, does not affect the action of the AuGe layer 23 (and therefore the action of the inverter circuit), if the AuGe layer 23 straddles the extending portion 22 of the gate electrode 13b and 13c in the drain-to-source direction and makes ohmic contact with the active region 12a there.

The extending portion 22 of the gate electrodes 13b and 13c and the AuGe layer 23 covering the extending portion 22 form an electrode 24 which serves as the source electrode of $Tr_1$ and the drain electrode of $Tr_2$. The drain region of $Tr_1$ and the source region of $Tr_2$ are connected to the gates 13b and 13c of $Tr_2$ and $Tr_3$ through the AuGe layer 23 and the extending portions 22 and 21. The AuGe layer 23 can be formed simultaneously in the step for forming the electrodes 14a and 14b. Reference numerals 17a, 17b and 16a, 16b refer to through holes and interconnection lines, respectively.

Figures 6 to 12 illustrate the steps of fabricating the inverter circuit of Fig. 4 and 5. The semi-insulating substrate 11 is a chromium (Cr) doped or undoped GaAs substrate having a resistivity of $10^6$ to $10^8$ ohm.cm. On the surface of the GaAs substrate 11, a silicon dioxide ($SiO_2$) layer 31 and a photoresist layer 32 are formed and selectively patterned so as to implant silicon (Si) ions into the substrate 11 by using the patterned layers 31 and 32 as a mask. Dosages of $1 \times 10^{12}$ $cm^{-2}$ and $2 \times 10^{12}$ $cm^{-2}$ and an implantation energy of 59 keV are used for making a region 33 for an enhancement-type channel of $Tr_1$ and a region 34 for a depletion-type channel of $Tr_2$, respectively (Fig. 6). The depth of the implantations is about 100 nm (1000Å), but the region 34 is slightly deeper in depth and slightly higher in impurity concentration than the region 33 due to the difference of their dosages.

After removing the photoresist and $SiO_2$ layers 31 and 32 and forming an approximately 100 nm (1000Å)-thick $SiO_2$ layer 35 on the surface of the substrate 11, the silicon (Si) ion implanted regions 33 and 34 are annealed at 850°C for 10 to 15 minutes in an atmosphere of nitrogen ($N_2$) + 10% hydrogen ($H_2$) (Fig. 7).

After removing the $SiO_2$ layer 35, an approximately 450 to 500 nm (4500 to 5000Å)-thick TiWSi layer is deposited on the substrate 11 by sputtering and is selectively dry etched so as to form gate electrodes 13a, 13b and 13c and their extending portions 21 and 22 (13c and 21 are not shown in Fig. 8), the width of the gate electrodes and the extending portion being about 1 µm (Fig. 8).

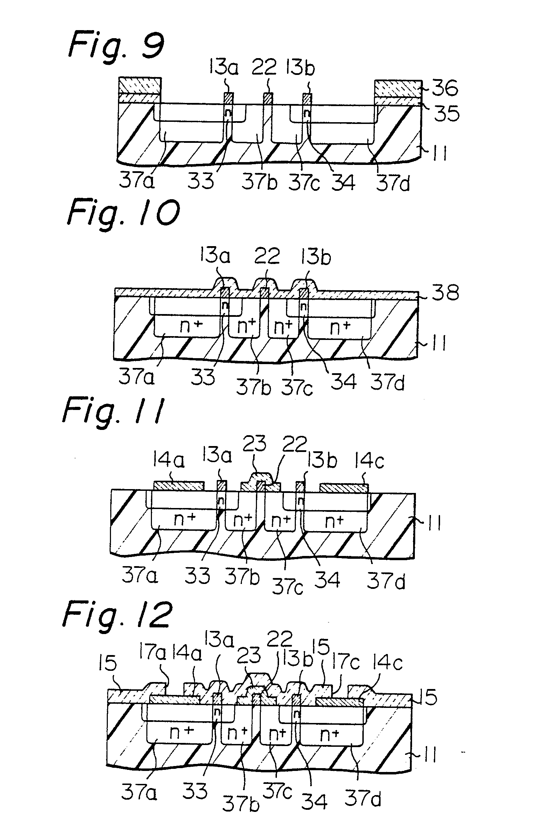

Then, silicon ions are implanted in a dosage of $1.7 \times 10^{13}$ $cm^{-2}$ and at an implantation energy of 175 keV to form active layers (i.e., a source region 37a, a drain region 37b of $Tr_1$, a source region 37c, and a drain region 37d or $Tr_2$) by using, as masks for ion implantation, patterned $SiO_2$ and photoresist layers 35 and 36 as well as the gate electrodes 13a and 13b and the extending portion 22 in the opening of the patterned layers 35 and 36 (Fig. 9). The ion implanted regions are annealed at 800°C for 5 to 10 minutes in an atmosphere of nitrogen ($N_2$) + 10% hydrogen ($H_2$) using a cover of a $SiO_2$ layer 38, resulting in a depth of the active layers 37a, 37b, 37c, 37d of about 300 nm (3000Å) (Fig. 10).

After removing the $SiO_2$ layer 38, ohmic contact electrodes 14a, 14c, and 23 are formed by depositing an approximately 30 to 35 nm (300 to 350Å)-thick AuGe layer and then an approximately 300 nm (3000Å)-thick gold layer on given portions by using a lift-off technique and annealing them at 450°C for 1 minute to make an alloy of the AuGe of the electrodes 14a, 14c and 22 and the GaAs of substrate (Fig. 11). The electrodes 13a, 13b, 14a, 14c, and 23 and the substrate 11 are covered with a $SiO_2$ layer 15 having a thickness of about 500 nm (5000Å), in which through holes 17a and 17c are opened to lead out interconnecting lines 16a and 16b made of a 50 nm (500Å)-thick titanium (Ti) layer and a 700 nm (7000Å)-thick gold layer thereon (Fig. 12 and Fig. 5).

In this example of the inverter circuit according to the present invention, the width of the electrode 24 (the size in the right-to-left direction in Fig. 4) can be about 4 µm instead of about 6 µm, as in the prior art example. Further, the distance between the active regions 12a and 12b can be about 6 µm since 2 µm distances are needed between the extending portion 21 of the gate electrodes 13b and 13c and the active regions 12a and 12b and a 2 µm width is needed for the extending portion 21, including the tolerances in alignment. Furthermore, the distance between the source region 37a or 37c and the drain region 37b or 37d, respectively, can be the same as the width of the gate electrode 13a or 13b itself, respectively, due to the self-alignment of the source and drain regions with the gate electrode by use of the gate electrode as a mask for forming the source and drain regions by ion implantation or diffusion, resulting in a decrease of that distance, i.e., the length of the gate. Thus, in accordance with the present invention, the semiconductor integrated circuit device having, e.g., the above described inverter circuit can be densified so as to improve the degree of integration of the device.

It should be noted that many other applications of the present invention can be made by those skilled in the art and that the invention is not limited to the above inverter circuit.

**Claims**

1. A semiconductor device comprising a semiconductor layer defining at least one n-type active region (12a) and an ohmic electrode (24) for the n-type active region consisting of different contact parts (22, 23); characterized in that the electrode (24) includes:

a first part (22) formed on and in contact with the semiconductor layer and extending to the n-type active region (12a), the first part (22) comprising a material selected from the group consisting of high melting-point metals and a silicide of the group of high melting-point metals, and appropriate for making Schottky contact with the n-type active region (12a); and,

a second part (23) formed on and in contact with both the n-type active region (12a) and at least a portion of said first part (22) of the electrode (24), the second part (23) comprising a material different from the material of the first part of the electrode, and appropriate for making ohmic contact with the n-type active region (12a), and the entire electrode (24), comprising the first and second parts, acting as an ohmic electrode for the n-type active region (12a).

2. A semiconductor device in accordance with claim 1 wherein the semiconductor layer defines a further n-type active region and a further electrode for this active region;

the further electrode (13b) being formed on and in contact with the further n-type active region and comprising a material selected from the group of high melting-point metals and a silicide of the group of high melting-point metals, for making Schottky contact with the further active region;

and the first part (22) of the ohmic electrode (24) comprising the same material as that of the further electrode (13b), and extending from the further electrode.

3. A semiconductor device in accordance with claim 2, wherein the one and the further active regions are formed as a single n-type active region.

4. A semiconductor device according to claim 1, 2 or 3 wherein the semiconductor layer comprises GaAs.

5. A semiconductor device according to any one of claims 1 to 4, wherein the first part (22) of the ohmic electrode (24) comprises a material selected from the group consisting of titanium and tungsten or a silicide thereof.

6. A semiconductor device according to claim 5, wherein the second part (23) of the ohmic electrode (24) comprises gold and germanium.

7. A semiconductor device according to claim 2, further comprising:

a first FET (TR2) having a gate electrode formed from the further electrode (13b); and

a second FET (TR1) having a source or drain electrode formed from the ohmic electrode (24).

8. A semiconductor device according to claim 2, further comprising:

a third n-type active region (12b) formed in the semiconductor layer; and

a third electrode (13c), comprising the same material as that of the further electrode (13b), formed on and in contact with the third n-type active region and extending from the further electrode (13b) and the first part (22) of the ohmic electrode (24), for making Schottky contact with the third n-type active region (12b).

9. A semiconductor device according to claim 8, further comprising:

a first FET (TR2) having a gate electrode formed from the further electrode (13b);

· a second FET (TR1) having a source or drain electrode formed from the ohmic electrode (24); and

a third FET (TR3) having a gate electrode formed from the third electrode (13c).

**Patentansprüche**

1. Halbleitervorrichtung mit einer Halbleiterschicht, die wenigstens einen aktiven n-Typ-Bereich (12a) und eine Ohmsche Elektrode (24) für den aktiven n-Typ-Bereich umfaßt, die aus verschiedenen Kontaktteilen (22, 23) besteht; dadurch gekennzeichnet, daß die Elektrode (24) umfaßt:

ein erstes Teil (22), welches auf und in Berührung mit der Halbleiterschicht gebildet ist und sich zu dem aktiven n-Typ-Bereich (12a) erstreckt, wobei das erste Teil (22) ein Material umfaßt, welches ausgewählt ist aus der Gruppe umfassend Metalle mit hohem Schmelzpunkt, und einem Silicid der Gruppe von Metallen mit hohem Schmelzpunkt, und welches geeignet ist, einen Schottky-Kontakt mit dem aktiven n-Typ-Bereich (12a) zu bilden und;

ein zweites Teil (23), welches auf und in Kontakt mit sowohl dem aktiven n-Typ-Bereich (12a) als auch wenigsten einem Abschnitt des genannten ersten Teils (22) der Elektrode (24) gebildet ist, wobei das zweite Teil (23) ein Material umfaßt, welches von dem Material des ersten Teils der Elektrode verschieden und geeignet ist, einem Ohmschen Kontakt mit dem aktiven n-Typ-Bereich (12a) zu bilden, und die gesamte Elektrode (24), die das erste und das zweite Teil umfaßt, als eine Ohmsche Elektrode für den aktiven n-Typ-Bereich (12a) wirkt.

2. Halbleitervorrichtung nach Anspruch 1, bei der die Halbleiterschicht einen weiteren aktiven n-Typ-Bereich und eine weitere Elektrode für diesen Bereich definiert;

die weitere Elektrode (13b) auf und in Kontakt mit dem weiteren n-Typ-Bereich gebildet ist und ein Material umfaßt, das ausgewählt ist aus der Gruppe von Metallen mit hohem Schmelzpunkt und einem Silicid aus der Gruppe von Metallen mit hohem Schmelzpunkt, um einen Schottky-Kontakt mit dem weiteren aktiven Bereich zu machen;

une das erste Teil (22) der Ohmschen Elektrode (24) dasselbe Material wie das der weiteren Elektrode (13b) umfaßt und sich von der weiteren Elektrode erstreckt.

3. Halbleitervorrichtung nach Anspruch 2, bei der der eine und der weitere aktive Bereich auf einem einzigen aktiven n-Typ-Bereich gebildet sind.

4. Halbleitervorrichtung nach Anspruch 1, 2 oder 3, bei der die Halbleiterschicht GaAs umfaßt.

5. Halbleitervorrichtung nach einem der Ansprüche 1—4, bei der das erste Teil (22) der Ohmschen Elektrode (24) ein Material umfaßt, welches ausgewählt ist aus der Gruppe bestehend aus Titan und Wolfram oder einem Silicid davon.

6. Halbleitervorrichtung nach Anspruch 5, bei der das zweite Teil (23) der Ohmschen Elektrode (24) Gold und Germanium umfaßt.

7. Halbleitervorrichtung nach Anspruch 2, ferner mit

einem ersten FET (TR2), der eine Gateelektrode hat, die aus der weiteren Elektrode (13b) gebildet ist; und

einem zweiten FET (TR1), der eine Source- oder Drainelektrode hat, die aus der Ohmschen Elektrode (24) gebildet ist.

8. Halbleitervorrichtung nach Anspruch 2, ferner mit:

einem dritten aktiven n-Typ-Bereich (12b), der in der Halbleiterschicht gebildet ist und

einer dritten Elektrode (13c), die dasselbe Material wie dasjenige der weiteren Elektrode (13b) umfaßt, die auf und in Kontakt mit dem dritten aktiven n-Typ-Bereich gebildet ist und sich von der weiteren Elektrode (13b) und dem ersten Teil (22) der Ohmschen Elektrode (24) erstreckt, um einen Schottky-Kontakt mit dem dritten aktiven n-Typ-Bereich (12b) zu bilden.

9. Halbleitervorrichtung nach Anspruch 8, ferner mit

einem ersten FET (TR2), dessen Gateelektrode aus der weiteren Elektrode (13b) gebildet ist;

einem zweiten FET (TR1), mit einer Source- oder Drainelektrode, die aus der Ohmschen Elektrode (24) gebildet ist; und

einem dritten FET (TR3), dessen Gateelektrode aus der dritten Elektrode (13c) gebildet ist.

**Revendications**

1. Composant à semi-conducteur comportant une couche semi-conductrice définissant au moins une région active (12a) de type N et une électrode ohmique (24) pour la région active de type N consistant en des parties de contact (22, 23) différentes; caractérisé en ce que l'électrode (24) comporte:

une première partie (22) formée sur et en contact avec la couche semi-conductrice et s'étendant jusqu'à la région active (12a) de type N, la première partie (22) consistant en une matière choisie dans le groupe consistant en des métaux à point de fusion élevé et en un siliciure du groupe des métaux à point de fusion élevé, et convenant pour établir un contact de Schottky avec la région active (12a) de type N; et

une seconde partie (23) formée sur et en contact avec à la fois la région active (12a) de type N et au moins une partie de la première partie (22) de l'électrode (24) la seonde partie (23) consistant en une matière différente de la matière de la première partie de l'électrode et convenant pour établir un contact ohmique avec la région active (12a) de type N et l'ensemble de l'électrode (24), comprenant la première et la seconde parties, se comportant comme une électrode ohmique pour la région active (12a) de type N.

2. Composant semi-conducteur selon la revendication 1, dans lequel la couche semi-conductrice définit une autre région active de type N et une autre électrode pour cette région active;

l'autre électrode (13b) étant formée sur et en contact avec l'autre région active de type N et consistant en une matière choisie dans le groupe de métaux à point de fusion élevé et un siliciure du groupe de métaux à point de fusion élevé pour établir un contact de Schottky avec l'autre région active;

et la première partie (22) de l'électrode ohmique (24) consistant en la même matière que celle de l'autre électrode (13b) et s'étendant à partir de l'autre électrode.

3. Composant à semi-conducteur selon la revendication 2, dans lequel ladite région active et l'autre région active sont formées comme une seule région active de type N.

4. Composant à semi-conducteur selon la revendication 1, 2 ou 3 dans lequel la couche semi-conductrice consiste en du GaAs.

5. Composant à semi-conducteur selon l'une quelconque des revendications 1 à 4, dans lequel la première partie (22) de l'électrode ohmique (24) consiste en une matière choisie dans le groupe comprenant le titane et le tungstène ou un de leurs siliciures.

6. Composant à semi-conducteur selon la revendication 5, dans lequel la seconde partie (23) de l'électrode ohmique (24) consiste en de l'or et en du germanium.

7. Composant à semi-conducteur selon la revendication 2, comportant en outre:

un premier FET (Tr2) ayant une électrode de grille formée à partir de l'autre électrode (13b); et

un second FET (Tr1) ayant une électrode de source ou de drain formée à partie de l'électrode ohmique (24).

8. Composant à semi-conducteur selon la revendication 2, comportant en outre:

une troisième région active (12b) de type N formée dans la couche semi-conductrice; et

une troisième électrode (13c) consistant en la même matière que celle de l'autre électrode (13b), formée sur et en contact avec la troisième région active de type N et s'étendant à partir de l'autre électrode (13b) et de la première partie (22) de l'électrode ohmique (24) pour établir un contact de Schottky avec la troisième région active (12b) de type N.

9. Composant à semi-conducteur selon la revendication 8, comportant en outre:

un premier FET (Tr2) ayant une électrode de grille formée à partir de l'autre électrode (13b);

un second FET (Tr1) ayant une électrode de source ou de drain formée à partie de l'électrode ohmique (24); et

un troisième FET (Tr3) ayant une électrode de grille formée à partir de la troisième électrode (13c).

# Fig. 1

# Fig. 2

# Fig. 3

# Fig. 4

## Fig. 5

24
{ 23 22 }

16a  17a  14a 13a  23  22  13b  17b  14c  16b

15

12a

n⁺  n⁺  n⁺  n⁺

11

## Fig. 6

33          34

32
31
11

## Fig. 7

33          34

35

n          n

11

## Fig. 8

33    13a  22  13b    34

n          n

11

## Fig. 9

13a 22 13b

36
35
11

37a 33 37b 37c 34 37d

## Fig. 10

13a 22 13b

38
11

$n^+$ $n^+$ $n^+$ $n^+$

37a 33 37b 37c 34 37d

## Fig. 11

14a 13a 23 22 13b 14c

11

$n^+$ $n^+$ $n^+$ $n^+$

37a 33 37b 37c 34 37d

## Fig. 12

15 17a 14a 13a 23 22 13b 15 17c 14c

15
11

$n^+$ $n^+$ $n^+$ $n^+$

37a 33 37b 37c 34 37d